# DEMANDE DE BREVET EUROPEEN

(11) **EP 0 587 500 A1**
(43) Date de publication de la demande: **16.03.1994**
(21) Numéro de dépôt: 93402195.7
(22) Date de dépôt: 09.09.1993
(51) Int. Cl.: H01S 3/19, G02B 6/12

(54) **Procédé de fabrication de dispositifs électro-optiques à ruban, notamment de lasers, et dispositifs ainsi obtenus**

(30) Priorité: 11.09.1992 FR 9210848
(71) Demandeur: FRANCE TELECOM, F-75015 Paris (FR)
(72) Inventeur: Loualiche, Slimane, F-22300 Lannion (FR); Vaudry, Claude, F-22300 Lanmerin (FR); Henry, Loic, F-22300 Lannion (FR)
(74) Mandataire: Martin, Jean-Jacques

(57) **Abrégé**

La présente invention concerne un procédé de fabrication d'un dispositif électro-optique à semi-conducteur comprenant une région active en forme de ruban, caractérisé par le fait qu'il comprend les étapes qui consistent à : i) réaliser les diverses couches (120, 130, 140, 150, 160) composant la structure complète du dispositif électro-optique, par une seule épitaxie, ii) graver la structure obtenue à l'étape i) jusqu'à la base de la couche active (130) du dispositif électro-optique, pour isoler un ruban dans celle-ci, et iii) déposer sur la zone gravée, un matériau électriquement isolant d'indice contrôlé (170). L'invention concerne également les dispositifs ainsi obtenus.

## Description

La présente invention concerne le domaine des dispositifs électro-optiques à semi-conducteur comprenant une région active en forme de ruban.

La présente invention s'applique en particulier, mais non exclusivement, aux lasers à semi-conducteur.

La structure laser à semi-conducteur la plus utilisée de nos jours est formée d'une double hétérojonction.

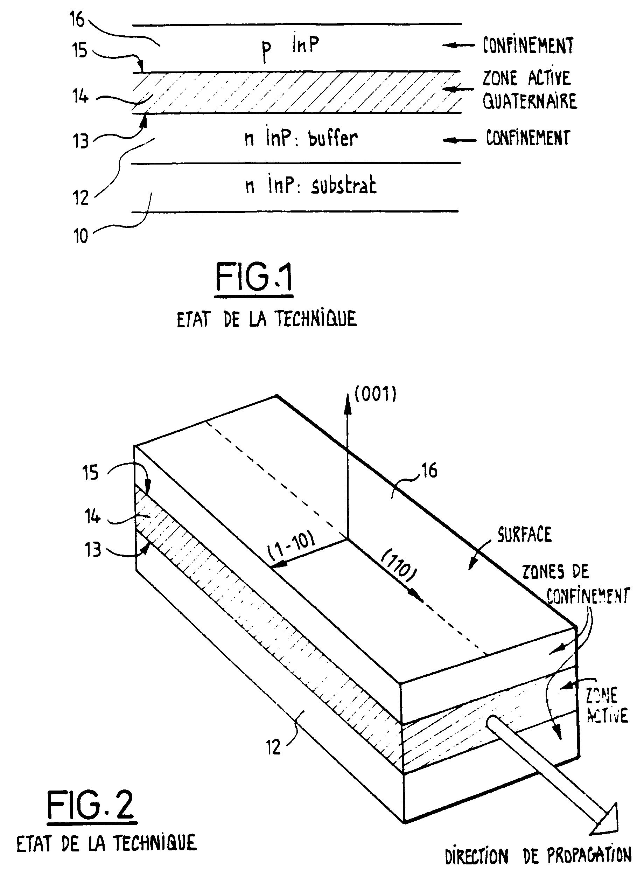

Les lasers à semi-conducteur formés d'une double hétérostructure comprennent généralement, comme représenté sur les figures 1 et 2 annexées, sur un substrat semiconducteur 10, une couche active 14 de matériau semiconducteur à faible intervalle de bande interdite qui amplifie la lumière réfléchie, par émission stimulée (la recombinaison de paires électrons/trous, donne lieu à une émission de lumière à une énergie proche de celle de l'intervalle de bande interdite du matériau), encadrée respectivement de part et d'autre de ses faces principales 13, 15, par des couches 12, 16 de matériaux semiconducteurs ayant des intervalles de bande interdite supérieurs.

Les lasers à semi-conducteur sont généralement fabriqués sur des substrats 10 en GaAs ou InP. Les lasers utilisés en télécommunications avec des longueurs d'onde de 1300nm et 1550nm utilisent l'InP comme substrat 10. Ceux ayant des longueurs d'ondes de 850nm et au-delà, jusqu'à 630 nm (pour lasers de disques compacts par exemple), sont fabriqués sur des substrats 10 en GaAs.

L'interface entre la couche active 14 et la couche sous-jacente 12, constitue la jonction p-n du laser.

Les deux couches 12, 16 de bandes interdites supérieures assurent le confinement transversal de la structure, soit perpendiculairement à la jonction formée entre la couche active 14 et la couche 12 adjacente de bande interdite supérieure.

La couche active 14 fait moins de 1000nm d'épaisseur (typiquement 200nm). Les couches 12 et 16 qui l'entourent sont plus épaisses. Elles sont généralement supérieures à 1000nm (typiquement 1500 et 2000nm).

Par ailleurs, la zone active 14 a un indice optique plus grand que les zones 12 et 16 qui l'entourent. Par exemple, pour un laser à double hétérostructure sur substrat 10 en InP émettant à 1550nm, la zone active 14 en GaInAsP fait 200nm et a un indice de 3,5, les zones de confinement optiques et électriques 12 et 16 qui sont en InP et font environ 1500nm d'épaisseur ont un indice de 3,2.

La lumière émise dans la région active 14, par recombinaison des porteurs, trous et électrons, est guidée par les indices faibles des couches de confinement 12 et 16. De préférence, on recherche un grand recouvrement entre la zone active 14 de gain où sont émis les photons et les couches guides 12 et 16.

La région active 14 est en outre confinée longitudinalement et latéralement.

Le confinement longitudinal est obtenu en clivant la structure cristallographique qui compose la région active 14, suivant les faces 110 ou 1-10, pour former deux miroirs.

Le faisceau se propage ainsi généralement dans la direction 100 qui correspond à la plus grande dimension de la couche active 14. Cette dimension est comprise entre 0,05mm pour les lasers courts et 1mm pour les lasers longs.

La largeur de la couche active 14, définie par le confinement latéral est généralement comprise entre 1000 et 2000nm.

Différentes techniques ont été proposées pour assurer le confinement latéral de la couche active 14, c'est-à-dire définir une zone active en ruban, moins large que le substrat 10.

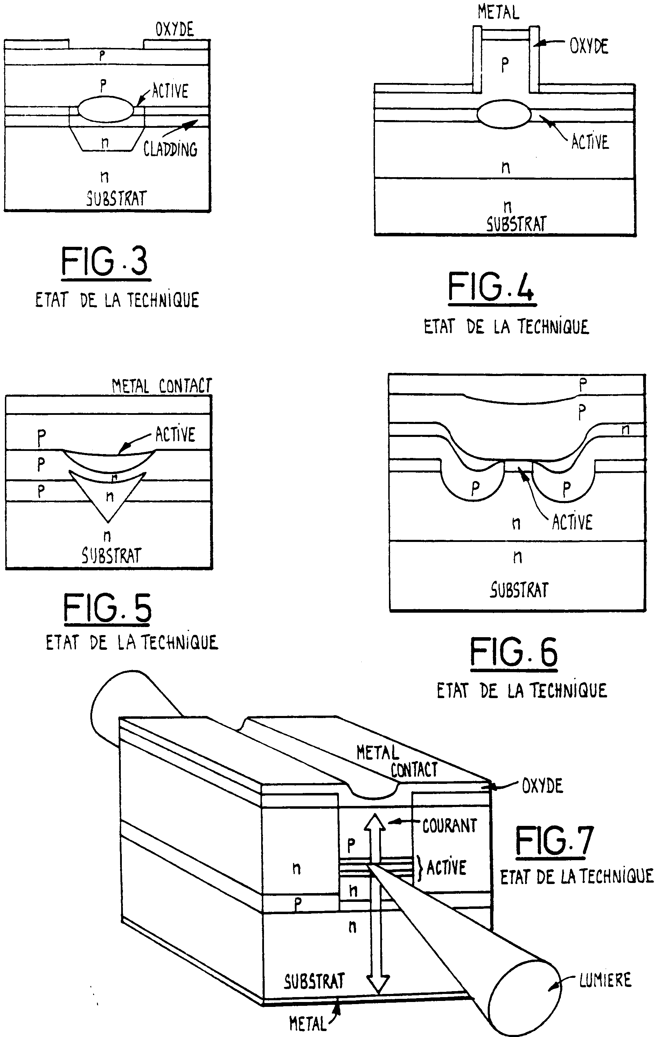

Cinq techniques connues de confinement latéral sont représentées schématiquement sur les figures 3 à 7.

Selon la première technique connue représentée sur la figure 3, on creuse un ruban rectangulaire dans le substrat de base et ont fait ensuite l'épitaxie de la zone active dans ce ruban. Cette technique permet d'obtenir un laser à canal enterré dans le substrat (channeled substrate planar laser).

Selon la seconde technique connue représentée sur la figure 4, une structure laser est entièrement réalisée en une seule croissance. Ensuite, le confinement latéral optique est obtenu en gravant toute la structure jusqu'à 200nm environ au-dessus de la zone active autour d'un ruban. Le ruban fait environ 1000nm à 3000nm de large pour avoir un mode stable. On dépose une couche d'oxyde pour l'isolement électrique partout sauf sur le ruban. Le contact au-dessus du ruban permet d'amener le courant. L'isolant près de la zone active (à 200 ou 300nm) permet par son indice faible au-dessus de cette zone d'empêcher le mode optique de se développer latéralement hors du ruban. Cette structure présente l'avantage de se faire sans reprise d'épitaxie. Cette structure porte le nom de ruban (ridge waveguide laser).

Selon une troisième technique connue représentée sur la figure 5, une gravure en V est creusée dans une couche épitaxiée. Une double hétérostructure est ensuite fabriquée par une reprise d'épitaxie par LPE (épitaxie en phase liquide) au-dessus de cette gravure en V en faisant en sorte de respecter la consigne qui est de mettre des zones n à l'intérieur du V en face de zones p à l'extérieur et vice versa pour avoir un bon confinement électrique latéral. Ceci est facilité par le fait qu'à la reprise d'épitaxie les couches sont plus épaisses au centre du V qu'aux extrémités. Ceci donne à ces couches une allure de croissant (d'où le nom Buried crescent laser/laser à croissant enterré). Cette structure ne peut être réalisée qu'en LPE.

Selon une quatrième technique connue représentée sur la figure 6, la structure dite DCPBH (double Channel Planar Buried Heterostructure laser) est obtenue à l'aide d'une gravure de deux canaux de part et d'autre d'un ruban qui sert de zone active. Une reprise d'épitaxie de zone n et p autour du ruban sur les canaux gravés permet de faire le confinement optique et électrique du laser. La réalisation de la reprise d'épitaxie se fait par LPE.

Selon une cinquième technique connue représentée sur la figure 7, on utilise une double épitaxie pour réaliser une structure dite BRS (Buried Ridge Structure). La première épitaxie permet de faire croître une couche tampon, puis les zones de confinement optique et électrique entourant la zone active. Ensuite, on définit un ruban de 1000 à 2000nm en gravant le matériau autour de ce ruban et on fait une reprise d'épitaxie avec un matériau de faible indice (le même que les zones de confinement au-dessus et en-dessous de la zone active).

Ces diverses techniques connues qui viennet d'être décrites ont rendu de grands services.

Toutefois, elles ne donnent pas totalement satisfaction.

On note tout d'abord que les diverses structures à guidage par l'indice représentées sur les figures 5, 6 et 7 font appel à une reprise d'épitaxie. Or, cette reprise d'épitaxie alourdit la technologie et augmente le temps de fabrication.

Par ailleurs, les structures représentées sur les figures 3 et 4, qui se font sans reprise d'épitaxie, et ont un guidage optique par le gain, donc faible, présentent un fonctionnement qui n'est pas très stable.

La présente invention a maintenant pour but de proposer une nouvelle structure de dispositif électrooptique à semi-conducteur comprenant une région active en forme de ruban, qui ne requiert pas de reprise d'épitaxie et qui de plus permette un fonctionnement parfaitement stable.

Ce but est atteint selon la présente invention grâce à un procédé de fabrication d'un dispositif électrooptique à semi-conducteur comprenant une région active en forme de ruban,
caractérisé par le fait qu'il comprend les étapes qui consistent à :
i) réaliser les diverses couches composant la structure complète du dispositif électrooptique, par une seule épitaxie,
ii) graver la structure obtenue à l'étape i) jusqu'à la base de la couche active du dispositif électrooptique, pour isoler un ruban dans celle-ci, et
iii) déposer sur la zone gravée, un matériau électriquement isolant, d'indice contrôlé.

La présente invention concerne également les dispositifs électrooptiques à semi-conducteur obtenus par la mise en oeuvre du procédé précité.

La présente invention s'applique notamment à la fabrication de laser à semi-conducteur, comme indiqué dans le préambule de la demande de brevet.

D'autres caractéristiques, buts et avantages de la présente invention apparaîtront à la lecture de la description détaillée qui va suivre, et en regard des dessins annexés donnés à titre d'exemple non limitatif et sur lesquels :
- les figures 1 à 7 précédemment décrites concernent l'état de la technique,
- la figure 8 représente un organigramme général du procédé conforme à la présente invention,
- la figure 9 représente l'évolution de l'indice optique du nitrure de silicium en fonction du débit d'azote,
- les figures 10 à 15 représentent schématiquement, sous forme de vue en coupe transversale, les diverses étapes d'une mise en oeuvre particulière du procédé conforme à la présente invention,

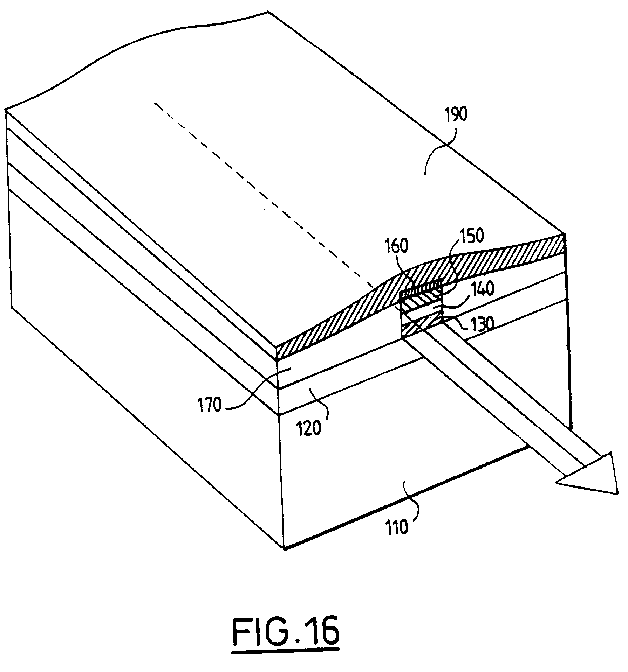

- la figure 16 représente une vue schématique en perspective d'un laser ainsi obtenu, et
- la figure 17 représente schématiquement l'évolution de la puissance du laser en fonction de l'intensité de commande de celui-ci.

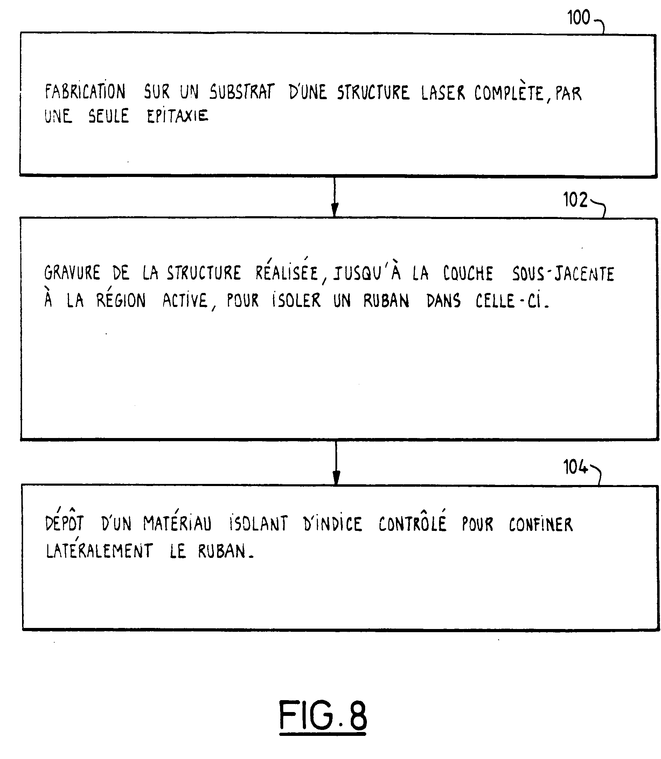

Comme indiqué précédemment et comme illustré sur la figure 8, le procédé conforme à la présente invention de fabrication d'un dispositif électrooptique à semiconducteur comprenant une région active en forme de ruban, comprend essentiellement les étapes qui consistent à :
i) réaliser les diverses couches composant la structure complète du dispositif électrooptique, par une seule épitaxie, comme représenté à l'étape 100 sur la figure 8,
ii) graver la structure obtenue à l'étape i) précitée jusqu'à la base de la couche active du dispositif électrooptique, pour isoler un ruban dans celle-ci, comme schématisé à l'étape 102 sur la figure 8, et
iii) déposer sur la zone gravée, un matériau électriquement isolant d'indice contrôlé, comme représenté à l'étape 104 sur la figure 8.

Dans le cadre d'une application à la fabrication d'un laser, l'étape i) consiste plus précisément, de préférence, à réaliser, au cours d'une seule épitaxie, une structure laser complète comprenant une première couche de confinement, une zone active, une seconde couche de confinement, et au moins une zone de contact ohmique.

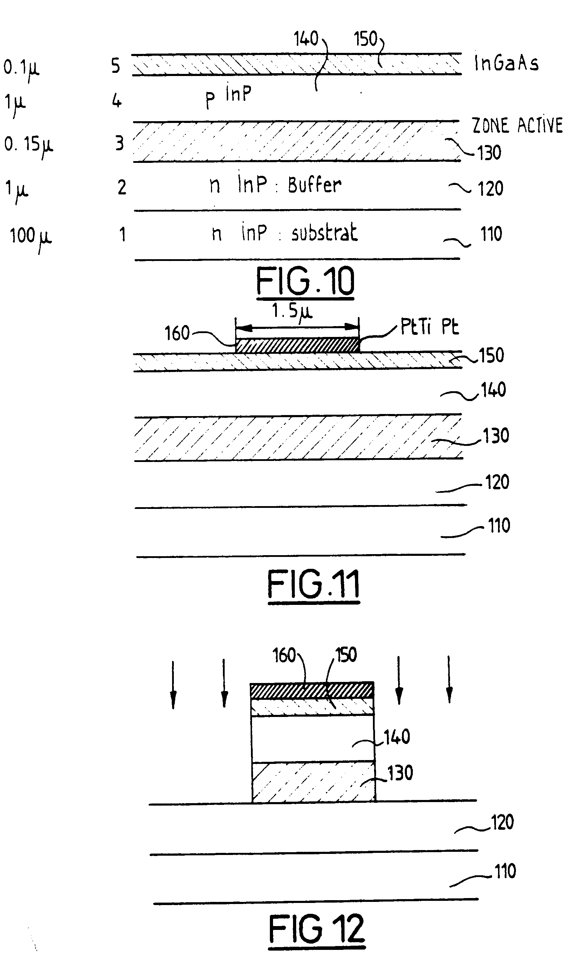

Un exemple particulier de réalisation sera décrit plus en détail par la suite en regard des figures 10 à 15.

Le matériau électriquement isolant d'indice contrôlé peut être déposé à l'étape iii) selon toute technique appropriée connue de l'homme de l'art. Il peut s'agir, sans que cette énumération soit limitative, d'un dépôt au canon à électrons, ou de technique connue sous les dénominations CVD (Chemical Vapor Deposition - Dépôt Chimique en Phase Vapeur), MOCVD (Metal Organic Chemical Vapor Deposition - Dépôt Chimique en Phase Vapeur aux organométalliques), etc ...

L'utilisation d'un matériau de confinement d'indice contrôlé permet d'obtenir un bon confinement optique. En outre, la propriété de grande résistivité électrique du matériau isolant déposé à l'étape iii) permet un bon confinement électrique.

L'indice du matériau électriquement isolant déposé à l'étape iii) peut être constant sur son épaisseur. En variante, pour affiner les propriétés de confinement optique, on peut prévoir un matériau d'indice variable sur son épaisseur, en faisant évoluer l'indice du matériau au cours de la phase de dépôt à l'étape iii).

Selon une caractéristique avantageuse de la présente invention, le matériau diélectrique d'indice contrôlé déposé à l'étape iii) est du nitrure de silicium.

Les inventeurs ont sélectionné ce matériau particulier après de nombreux essais.

Le nitrure de silicium offre de nombreux avantages dans le cadre de la mise en oeuvre de l'invention, parmi lesquels on peut citer :
- une parfaite adaptation aux flancs du ruban gravé, sans génération de défaut sur ceux-ci,
- large plage d'évolution de l'indice puisque l'indice du matériau peut varier de 3,8 pour du silicium amorphe, à 2,8 pour du nitrure de silicium si₃N₄. Le nitrure de silicium est donc adapté pour remplacer des matériaux semiconducteurs III-IV pour lesquels l'indice évolue généralement entre 3 et 3,5 à la longueur d'onde de 1550nm.
- la résistivité du nitrure de silicium est supérieure à 10⁹Ωcm.
- le nitrure de silicium est l'un des matériaux de base les plus purs que l'on puisse trouver industriellement.
- le nitrure de silicium est facile à évaporer.
- le nitrure de silicium n'est pas cher.
- le nitrure de silicium n'est pas toxique.

La composition du nitrure de silicium, et donc son indice, peut être contrôlée aisément par un débit d'azote.

La technologie de travail du nitrure de silicium, en particulier dépôt, gravure, recuit ... est bien connue en micro-électronique.

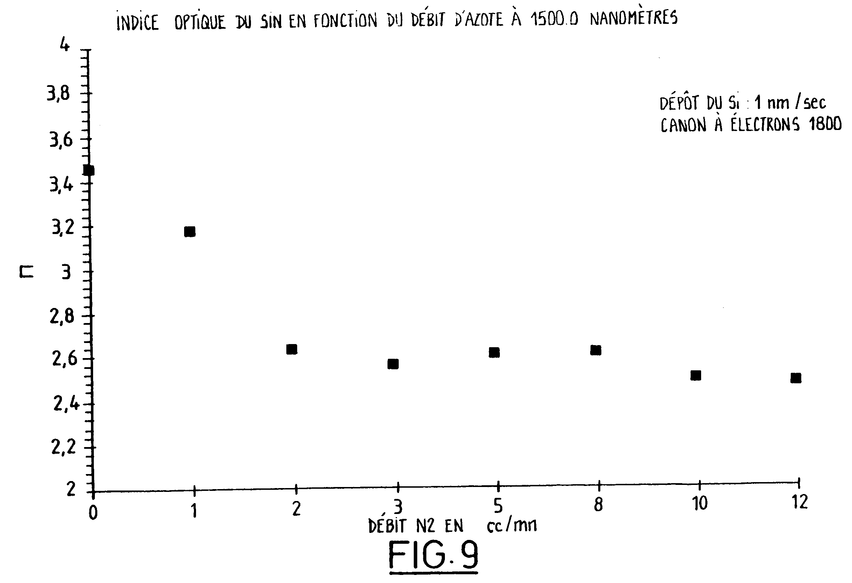

Les inventeurs ont étudié l'indice du nitrure de silicium déposé par canons à électrons en fonction du débit d'azote. La courbe résultante mesurée est donnée sur la figure 9 annexée.

Cette figure 9 montre que l'indice du matériau déposé à l'étape iii) peut aisément être contrôlé par le débit d'azote.

Bien entendu la présente invention n'est pas limitée à cet exemple de réalisation particulier et s'étend d'une façon plus générale au contrôle de l'indice d'un matériau électriquement résistant déposé à l'étape iii) par contrôle de l'atmosphère environnante, sans que celle-ci soit composée exclusivement d'azote.

On va maintenant décrire plus en détail un exemple de mise en oeuvre du procédé conforme à la présente invention, en regard des figures 10 à 15.

Selon l'exemple de réalisation représenté sur ces figures, les inventeurs ont réalisé les diverses couches composant une structure laser complète à base de double hétérostructure, par une épitaxie unique, par jet moléculaire à source gazeuse (GSMBE).

Plus précisément encore, comme représenté sur la figure 10, les inventeurs sont partis d'un substrat 110 en InP de type n+ sur lequel ils ont fait croître une première couche tampon 120, servant de confinement, en InP de type n⁺ de 1000nm d'épaisseur. La couche 120 est suivie d'une couche de quaternaire GaInAsP 130 non dopée d'épaisseur de l'ordre de 150nm. Cette couche 130 constitue la zone active. Elle permet d'obtenir une émission laser à une longue d'onde de 1550nm. Ensuite, les inventeurs ont déposé une seconde couche de confinement 140 à base d'InP dopée p, de 1000nm d'épaisseur, et enfin une couche 150 de ternaire GaInAs d'une épaisseur de l'ordre de 100nm, qui sert à la prise de contact ohmique.

Une fois l'épitaxie achevée, comme représenté sur la figure 10, les inventeurs ont procédé au dépôt d'un ruban métallique 160 de Ti/Pt/Ti de 1500nm d'épaisseur, sur la couche de contact ohmique 150. Ce ruban métallique définit la dimension latérale du ruban laser. Il est visible sur la figure 11. Le ruban 160 peut aussi être formé de Pt/Ti/Pt.

Le dépôt du ruban métallique 160 est recuit à 400°C pendant deux minutes. La structure a ensuite été gravée par gravure ionique réactive méthane + hydrogène + Argon (RIE : CH₄ + H₂ + Ar).

Au cours de cette opération de gravure, le ruban métallique 160 sert de masque de gravure.

La gravure est arrêtée à la base de la zone active 130, c'est-à-dire lorsque la couche de confinement inférieure 120 est atteinte, comme représentée sur la figure 12. Le cas échéant la gravure peut être poursuivie au delà de la zone active 130, dans la couche de confinement 120, selon les propriétés du dispositif que l'on désire avoir.

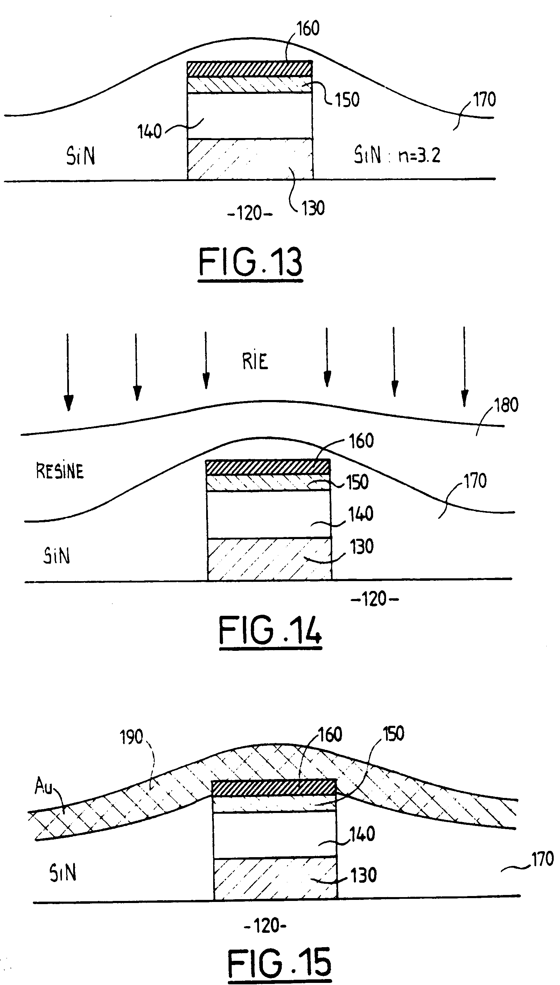

L'étape ii) du procédé étant ainsi achevé, les inventeurs ont ensuite déposé au canon à électrons une couche de SiN de 1000nm d'épaisseur environ sur toute la surface du dispositif, y compris sur le ruban formé à l'étape de gravure, comme représenté sur la figure 13.

L'indice du nitrure de silicium ainsi déposé était contrôlé pour être égal à celui de l'InP formant les couches de confinement, soit de 3,2 à la longueur d'onde de travail 1550nm.

La couche de nitrure de silicium déposée à l'étape iii) est visible sur la figure 13 sous la référence 170.

Les inventeurs ont ensuite opéré un dépôt de résine 180 d'une épaisseur de l'ordre de 5000nm sur l'ensemble du dispositif, pour planariser la structure, comme représenté sur la figure 14.

La structure est ensuite gravée sur toute la surface, sans masque, par gravure sèche (RIE) comme schématisée sur la figure 14. Au cours de cette étape de gravure, la couche de résine 180 permet de protéger la couche de nitrure de silicium déposée sur l'extérieur du ruban. On comprend en effet à l'examen de la figure 14 que la couche de résine 180 présente une épaisseur supérieure sur l'extérieur du ruban gravé, qu'elle ne l'est à la verticale de celui-ci.

La gravure schématisé à l'étape 14 a été arrêtée lorsque le métal 160 couvrant le ruban a été atteint. On notera que cette couche de métal 160 n'est pas gravé par la RIE.

Les inventeurs ont ensuite éliminés la couche restante de résine 180 par un solvant chimique.

On obtient ainsi une structure comprenant un ruban métallique 160 de contact ohmique apparent environné de nitrure de silicium 170 qui sert au confinement latéral optique grâce à son indice n de 3,2 et électrique grâce à sa résistivité élevée.

Comme schématisé sur la figure 15, les inventeurs ont ensuite déposé un large ruban métallique d'or 190 sur la couche métallique 160 et le nitrure de silicium environnant. Le ruban d'or présente typiquement une largeur de 0,1mm et une épaisseur de 300nm. Il sert à la prise de contact par soudure de fil d'or.

De préférence, pour assurer le contact sur la face opposée du substrat 110, on procède successivement au dépôt d'une fine couche d'AuGe ou équivalent suivi d'un dépôt d'un épaississement d'or ou de platine.

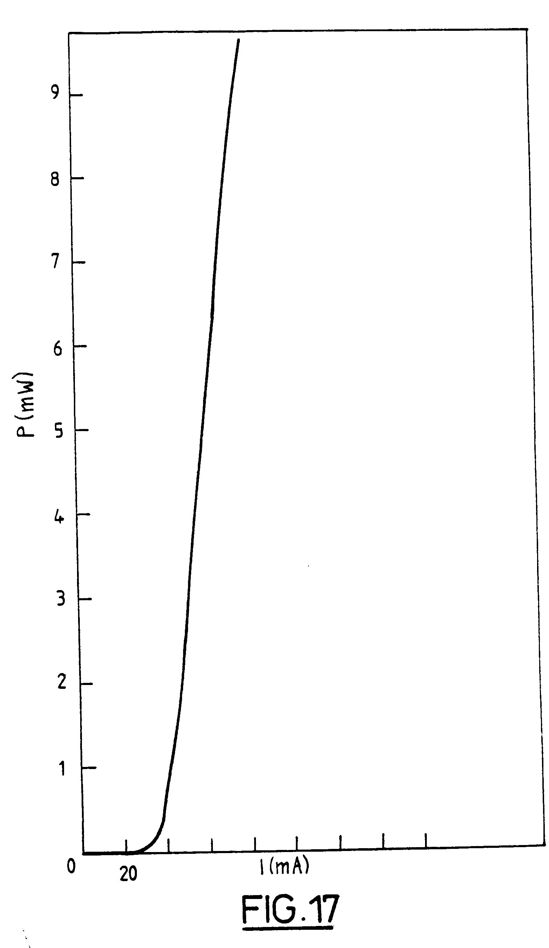

On a illustré sur la figure 17 annexée, la puissance obtenue en sortie de la structure laser ainsi formée en fonction de l'intensité de commande.

La structure testée présente un courant de seuil d'environ 50mA de moyenne par laser, et de 35mA pour le meilleur laser. Ce dernier présente un rendement de 0,2W/A.

La résistance de série de la diode laser varie entre 2 et 4 Ω pour une longueur de ruban de 0,3mm. Le laser émet à une longueur d'ondes de 1500nm.

Les tests réalisé sur les structures fabriquées par les inventeurs ont révélé les points suivants :
- très bonne stabilité de la sortie du laser due notamment au bon comportement optique latéral obtenu par le guidage par l'indice grâce au nitrure de silicium 170.
- bon confinement électrique obtenu avec le nitrure de silicium 170.
- diminution des capacités parasites grâce au matériau diélectrique 170 permettant d'augmenter les fréquences de fonctionnement des dispositifs rapides.
- bon rendement et bonne fiabilité en raison notamment de l'utilisation d'une épitaxie unique.
- simplicité du processus de fabrication du type technologie auto alignée avec un seul masque de dimension fine (environ 1500nm).

L'utilisation de nitrure de silicium à indice contrôlé par débit d'azote et dont l'indice peut reproduire pratiquement toutes les valeurs des matériaux III-IV permet une bonne flexibilité. Il permet aussi une réalisation aisée : plusieurs techniques de dépôt peuvent être utilisées. Un bon contrôle de la dimension du mode optique peut être obtenu par le contrôle de l'indice du matériau.

Enfin, la présente invention permet une diminution des courants de fuite grâce à la grande résistivité du nitrure de silicium 170.

Bien entendu la présente invention n'est pas limitée à l'utilisation particulière du nitrure de silicium 170 mais s'étend, d'une façon générale, à l'utilisation de tout matériau équivalent.

Par ailleurs, l'invention n'est pas limitée à la réalisation de structures laser mais s'étend à la réalisation de tout dispositif électro-optique à semiconducteur comprenant un ruban et nécessitant un confinement électrique et optique, tel que par exemple les modulateurs et amplificateurs électro-optiques.

## Revendications

1. Procédé de fabrication d'un dispositif électro-optique à semi-conducteur comprenant une région active en forme de ruban, caractérisé par le fait qu'il comprend les étapes qui consistent à :
i) réaliser les diverses couches (120, 130, 140, 150, 160) composant la structure complète du dispositif électro-optique, par une seule épitaxie,
ii) graver la structure obtenue à l'étape i) jusqu'à la base de la couche active (130) du dispositif électro-optique, pour isoler un ruban dans celle-ci, et
iii) déposer sur la zone gravée, un matériau électriquement isolant d'indice contrôlé (170).

2. Procédé selon la revendication 1, caractérisé par le fait que le dispositif électro-optique à semiconducteur est un laser.

3. Procédé selon l'une des revendications 1 ou 2, caractérisé par le fait que l'étape i) consiste à déposer successivement une première couche de confinement transversale (120), une couche de matériau active (130), une seconde couche de confinement transversale (140) et au moins une couche de contact ohmique (150, 160).

4. Procédé selon l'une des revendications 1 à 3, caractérisé par le fait que le matériau électriquement isolant (170) déposé à l'étape iii) possède un indice constant sur son épaisseur.

5. Procédé selon la revendication 4, caractérisé par le fait que l'indice du matériau électriquement isolant (170) déposé à l'étape iii) est au moins sensiblement égal à l'indice des couches de confinement (120, 140).

6. Procédé selon l'une des revendications 1 à 3, caractérisé par le fait que l'indice du matériau électriquement isolant (170) déposé à l'étape iii) est variable sur son épaisseur.

7. Procédé selon l'une des revendications 1 à 6, caractérisé par le fait que le matériau électriquement isolant déposé à l'étape iii) est du nitrure de silicium.

8. Procédé selon l'une des revendications 1 à 7, caractérisé par le fait que l'indice du matériau électriquement isolant déposé à l'étape iii) est contrôlé par l'atmosphère environnante au cours de l'étape iii).

9. Procédé selon l'une des revendications 1 à 8, caractérisé par le fait que le matériau électriquement isolant (170) déposé à l'étape iii) est du nitrure de silicium dont l'indice est contrôlé par contrôle du débit d'azote.

10. Procédé selon l'une des revendications 1 à 9, caractérisé par le fait que l'étape i) consiste à déposer successivement une première couche de confinement (120) en InP de type n⁺, une couche active (130) quaternaire de GaInAsp, une seconde couche de confinement transversale en InP de type p et une couche ternaire (150) de GaInAs pour la prise de contact ohmique.

11. Procédé selon la revendication 10, caractérisé par le fait que l'étape ii) consiste à déposer un ruban métallique (160) servant de masque avant d'opérer une gravure ionique.

12. Procédé selon l'une des revendications 10 ou 11, caractérisé par le fait que l'étape iii) consiste à déposer une couche de nitrure de silicium d'une épaisseur de l'ordre de 1000nm.

13. Procédé selon l'une des revendications 10 à 12, caractérisé par le fait qu'il comprend en outre les étapes consistant à :
- déposer sur toute la surface de la structure obtenue une couche de résine (180) destinée à planariser la structure,
- opérer une gravure pour mettre à jour la couche métallique (160) servant de masque de gravure au cours de l'étape de gravure ii),
- éliminer à l'aide d'un solvant la couche de résine restante,
- puis opérer un dépôt de prise de contact.

14. Dispositif électro-optique obtenu par la mise en oeuvre du procédé conforme à l'une des revendications 1 à 13.

15. Dispositif électro-optique selon la revendication 14, caractérisé par le fait qu'il constitue un laser.

16. Dispositif électro-optique selon l'une des revendications 14 ou 15, caractérisé par le fait qu'il comprend une structure complète (120, 130, 140, 150, 160) réalisée par une seule épitaxie, dans laquelle un ruban est gravé jusqu'à la base de la couche active (130) du dispositif, lequel ruban est entouré de part et d'autre par un dépôt de matériau électriquement isolant d'indice contrôlé (170).

17. Dispositif selon l'une des revendications 14 à 16, caractérisé par le fait que le matériau électriquement isolant d'indice contrôlé (170) est du nitrure de silicium.
